# EUROPEAN PATENT APPLICATION

(11) **EP 1 622 441 A2**
(43) Date of publication of application: **01.02.2006**
(21) Application number: 05016690.9
(22) Date of filing: 01.08.2005
(51) Int. Cl.: H05K 13/04

(54) **Electronic component mounting apparatus**

(30) Priority: 30.07.2004 JP 2004223625
(71) Applicant: Hitachi High-Tech Instruments Co., Ltd., Ora-gun, Gunma-ken, 370-0596 (JP)
(72) Inventor: Kano, Yoshinori, Oragun, Gunma (JP); Usui, Yoshinao, Tatebayashi, Gunma (JP); Takemura, Ikuo, Oragun, Gunma (JP); Moriaya, Yuji, Tatebayashi, Gunma (JP); Yamaguchi, Haruhiko, Ota-shi, Gunma (JP); Okamoto, Manabu, Isesaki-shi, Gunma (JP); Izuhara, Koichi, Oragun, Gunma (JP); Kurata, Kenji, Ota-shi, Gunma (JP); Asai, Jun, Ota-shi, Gunma (JP)
(74) Representative: Glawe, Delfs, Moll

(57) **Abstract**

The invention is directed to performing electronic component mounting operations by the suction nozzles of the mounting heads (8) in each of the plurality of the rotary tables (4A) independently, moving each of the positioning tables (4A) for positioning a printed board (Y) in a component mounting position independently, and performing the electronic component mounting operation on the plurality of the printed boards (Y) independently. A component feeding device moves a plurality of component feeding tables (12) having a plurality of component feeding units in an arraying direction thereof respectively and independently. Mounting heads (8) having a plurality of suction nozzles for picking up electronic components from the component feeding devices respectively are provided at predetermined intervals corresponding to intermittent pitches on an outer circumference of two rotary tables (7) intermittently rotating. Therefore, the suction nozzle of the mounting head (8) of each of the rotary tables (7) picks up the electronic component fed to a component pickup position in each of the component feeding units set on each of the component feeding tables (12), and mounts the component on the printed board (Y) on the corresponding positioning table (4A).

## Description

### Field of the Invention

The invention relates to an electronic component mounting apparatus for picking up an electronic component from a component feeding unit by a suction nozzle provided on a mounting head and mounting the electronic component on a printed board.

### Description of the Related Art

This type of electronic component mounting apparatus is described in Japanese Patent No. 3078614 and so on. There is disclosed the technology of providing the apparatus with a plurality of mounting devices performing the same operations at the same time, and a mounting member positioning device including a main table moving in a horizontal direction and positioning itself in a component mounting position and a correction device provided in each of the mounting devices, which can move each of the same types of printed boards set on this main table.

However, the plurality of the mounting devices performs the same operations at the same time, and can not perform each of the operations independently. Therefore, when trouble occurs in one of the mounting devices, the whole electronic component mounting apparatus need be stopped, so that its productivity reduces. Furthermore, the mounting member positioning device includes the main table moving a mounting member in the horizontal direction and positioning it in the component mounting position and a correction device provided for each of the mounting devices, which can move each of the same types of printed boards set on this main table independently. Therefore, the apparatus has many drive sources and a complex structure. It is thus an object of this invention to provide an electronic component mounting apparatus that lessens these drawbacks.

### SUMMARY OF THE INVENTION

The solution according to the invention lies in the features of the independent claims and preferably in those of the dependent claims.

The invention provides an electronic component mounting apparatus that includes two or more of component feeding units that are aligned in an alignment direction and movable along the alignment direction, and two or more of rotary tables that are aligned in the alignment direction. Each of the rotary tables has a plurality of mounting heads disposed at peripheral portions of the rotary table for picking up electric components from the component feeding units. The apparatus also includes two or more of positioning tables that are aligned in the alignment direction. Each of the positioning tables positions a printed board so that the electric components picked up by the mounting heads are mounted on the printed board.

The invention also provides an electronic component mounting apparatus that includes two or more of component feeding tables that are aligned in an alignment direction and movable along the alignment direction. Each of the component feeding tables has more than one component feeding unit. The apparatus also includes two or more of rotary tables that are aligned in the alignment direction. Each of the rotary tables has a plurality of mounting heads disposed at peripheral portions of the rotary table for picking up electric components from the component feeding units. The apparatus further includes two or more of positioning tables that are aligned in the alignment direction. Each of the positioning tables positions a printed board so that the electric components picked up by the mounting heads are mounted on the printed board.

According to the invention, the operation of mounting electronic components on a plurality of the printed boards can be performed by the mounting heads in each of the plurality of rotary tables independently. By virtue of this the operations can be applied to various printed boards such as the plurality of printed boards having no relation to each other or printed boards which is to complete the mounting operation of all the components by both rotary tables in such a manner that the printed board having electronic components mounted by one rotary table is then mounted with the electronic components by the other rotary table. Further, the positioning tables for positioning the printed board on the component mounting position can be moved respectively and independently, and the structure of the apparatus is thus simplified. This allows for the operation of mounting the electronic components on the plurality of the printed boards to be performed independently.

### BRIEF DESCRIPTION OF THE DRAWINGS

Fig. 1 is a schematic plan view of an electronic component mounting apparatus of the invention.
Fig. 2 is a schematic plan view of the electronic component mounting apparatus showing XY tables and component feeding tables at multiple stages.
Fig. 3 is a side view of the electronic component mounting apparatus partially sectioned.
Fig. 4 is a view showing an electronic component mounting operation of a first embodiment of the invention.
Fig. 5 is a view showing an electronic component mounting operation of a second embodiment of the invention.
Fig. 6 is a view showing an electronic component mounting operation of a third embodiment of the invention.

### DESCRIPTION OF THE PREFERRED EMBODIMENT

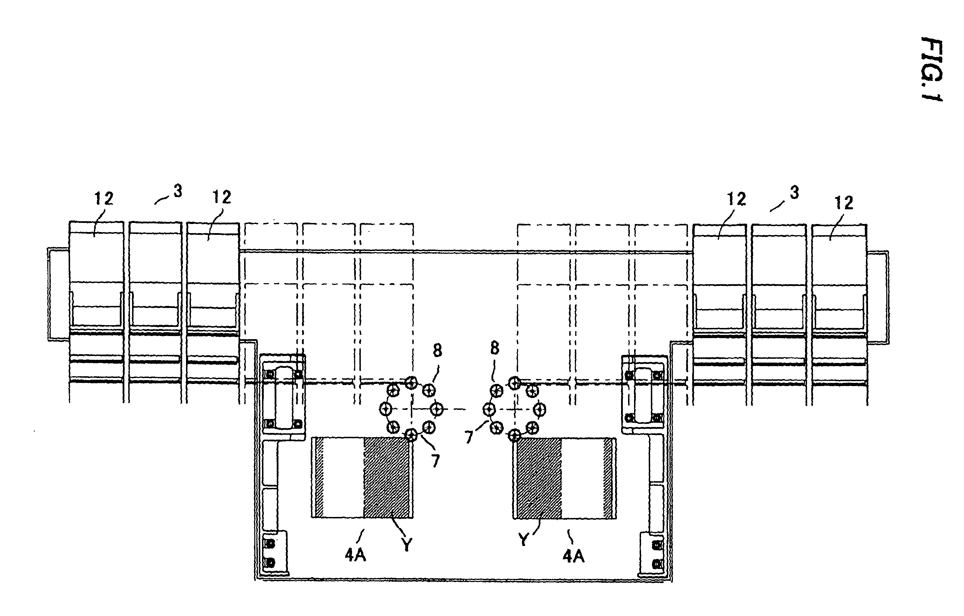

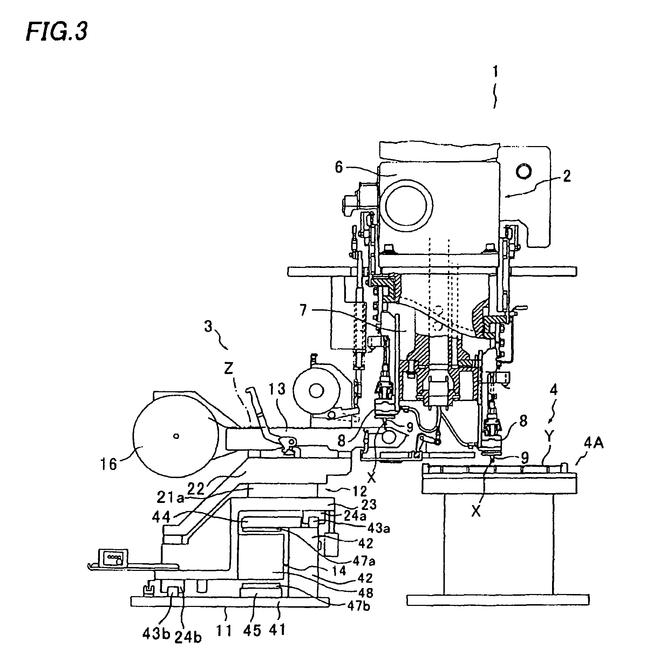

An electronic component mounting apparatus of an embodiment of the invention will be described with reference to Figs. 1-3. In an electronic component mounting apparatus 1, a feeding system 3 for feeding electronic components X and a mounting system 4 for mounting the electronic components X on a printed board Y are disposed in parallel with each other with apparatus bodies 2 interposed therebetween, the apparatus bodies 2 being disposed in a conveying direction of the printed board Y, which is the longitudinal direction of the apparatus shown in FIG. 1. The feeding system 3 includes an electronic component feeding device.

Each of the apparatus bodies 2 has an index unit 6 as a main body of a drive system including a drive motor, a rotary table 7 connected to the index unit 6 and rotating independently and intermittently, and a plurality (for example, eight) of mounting heads 8 disposed at predetermined intervals corresponding to intermittent pitches on an outer circumference of the rotary table 7. The rotary table 7 intermittently rotates by predetermined pitches corresponding to the number of the mounting heads 8, driven by the index unit 6. By intermittent rotation of the rotary table 7, any one of four suction nozzles 9 mounted on each of the mounting heads 8 moves to the feeding system 3 or the mounting system 4 as appropriate. That is, the suction nozzle 9 moves to the feeding system 3 in order to pick up the electronic component X fed by the feeding system 3, and then moves by rotating to the mounting system 4 in order to mount the electronic component X on the printed board Y conveyed to the mounting system 4.

The electronic component feeding device of the feeding system 3 has a base 11 extending in a lateral direction, six component feeding tables 12 slidably mounted on the base 11, twenty component feeding units 13 detachably set on each of the component feeding tables 12, and a linear motor 14 provided between the base 11 and each of the component feeding tables 12.

The component feeding units 13 are formed thin, and aligned in a lateral direction at narrow intervals on the component feeding tables 12. Each of these component feeding units 13 is positioned on the component feeding table 12 and mounted thereon being detachable by a lever. Each of the mounting heads 8 (suction nozzles 9) of the apparatus body 2 moves to each end of the component feeding units 13 mounted on the component feeding tables 12 to pick up the electronic component X by suction. In each of the component feeding units 13, a carrier tape Z having the electronic components X therein at predetermined pitches is wound around a tape reel 16. Each of the electronic components X stored in the carrier tape Z is picked up by the suction nozzle 9 from the carrier tape Z let out from the tape reel 16.

The component feeding table 12 has a base block 22 on an upper side and a slide block 23 having a crank-shaped cross-section on a lower side, which are positioned and fixed by left and right connecting members 21a. The component feeding units 13 are mounted on an upper surface of the base block 22, and a pair of front and rear sliders 24a and 24b is provided on a lower surface of the slide block 23.

The base 11 includes a base body 41 and a vertical block 42. A first slide rail 43a engaged with the first slider 24a is attached to an end portion of an upper surface of the vertical block 42. A second slide rail 43b engaged with the second slider 24b is attached to an end portion of an upper surface of the base body 41. An upper magnet base 44 is attached to the upper surface of the vertical block 42, extending in a horizontal direction. A lower magnet base 45 is attached to the upper surface of the base body 41, facing toward the upper magnet base 44.

The linear motor 14 has a pair of upper and lower stationary members 47a and 47b fixed to the base 11 and a moving member 48 fixed to the component feeding table 12. The stationary members 47a and 47b include the upper and lower magnet bases 44 and 45 and upper and lower magnets (not shown). The upper magnet is fixed to a lower surface of the upper magnet base 44 downward, and the lower magnet is fixed to an upper surface of the lower magnet base upward. The moving member 48 has substantially the same length as that of the component feeding table 12 and is fixed to a side surface of a vertical portion of the slide block 23. In this state, an upper surface and a lower surface of the moving member 48 face the upper stationary member 47a and the lower stationary member 47b respectively with gaps (air gaps) therebetween. That is, the moving member 48 and both the upper and lower stationary members 47a and 47b are facing each other, to operate as the linear motor 14 as a whole.

The moving member 48 fixed to each of the slide blocks 23 is formed by winding an exciting coil around a magnetic core (not shown), while the upper and lower stationary members 47a and 47b are formed by aligning many magnets in a longitudinal direction on the upper and lower magnet bases 44 and 45.

Numerals 4A designate XY tables as positioning tables forming the mounting system 4, which are arrayed in the conveying direction of the printed board Y and respectively and independently move in the X and Y directions by an X axis drive motor and a Y axis drive motor (both not shown). The printed board Y to be mounted with the electronic component X is conveyed to each of the XY tables along a pair of conveying chutes (not shown), and positioned and fixed thereon by each of positioning devices.

As described above, electronic components each fed to each of component pickup positions of the component feeding units 13 on the left and right six component feeding tables 12 are picked up by the suction nozzles 9 of the mounting heads 8 of each of the rotary tables 7, and the electronic components X can be respectively and independently mounted on each of the printed boards Y on the corresponding XY tables 4. In this case, the component feeding tables 12 can respectively and independently move in an array direction of the tables 12, which is the longitudinal direction of the apparatus shown in FIG. 1, so as to pick up the electronic components X by the suction nozzles 9 on each of the rotary tables 7 from the component feeding units 13 on any one of the component feeding tables 12.

It is noted that the electronic component feeding device, the rotary tables 7, and the XY tables 4A are integrally provided on a device mount.

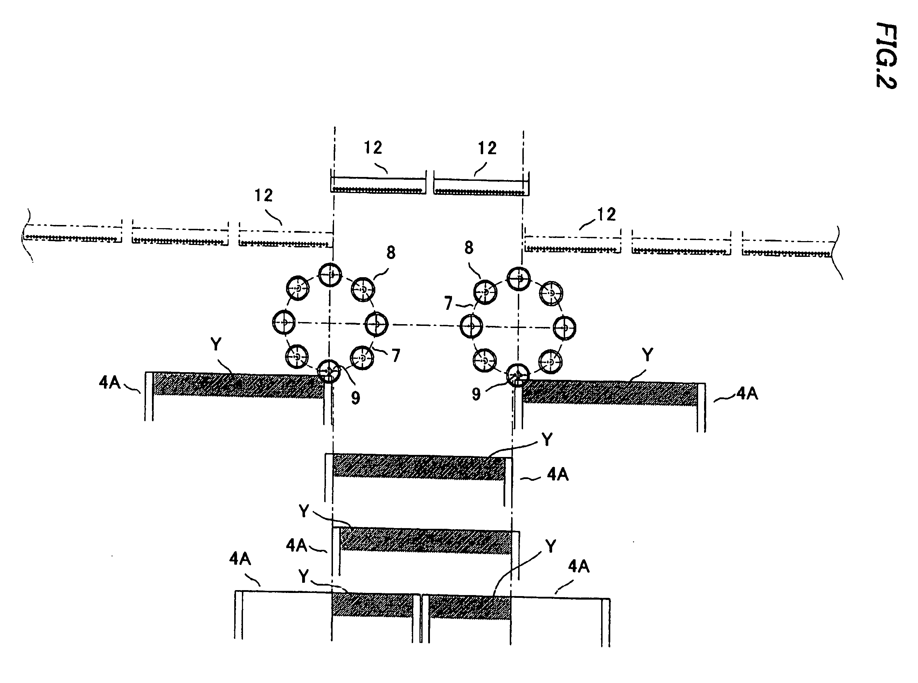

A position where the mounting head 8 of each of the rotary tables 7 stops for picking up the electronic component by suction from the component feeding unit 13 by its suction nozzle 9 (a position of 12 o'clock in Fig. 1 and Fig. 2) is a pickup station. At the pickup station, the suction nozzle 9 picks up the component by suction. A third position where the mounting head 8 stops from the pickup station is a recognition station. At the recognition station, a component recognition camera (not shown) takes an image of a lower surface of the electronic component held by suction by the pickup nozzle 9.

The next position after the recognition station is an angle correction station. At the angle correction station, a positional shift of a rotation angle of the electronic component held by suction by the suction nozzle 9 is corrected by rotating the mounting head 8 in a θ direction by a head rotation device (not shown) having a θ axis drive motor based on a recognition result by a recognition processing device (not shown) recognizing the image taken by the component recognition camera. The next stop position after the angle correction station is a mounting station. At the mounting station, a positional shift of the electronic component held by suction by the suction nozzle 9 in the X and Y directions based on the recognition result is corrected by the X axis drive motor and the Y axis drive motor, and the electronic component held by suction by the suction nozzle 9 is mounted on the printed board 6 on the XY table 4A.

As schematically shown in second and third rows of XY tables 4A from the top in Fig. 2, the length between centers of the left and right rotary tables 7 is a little longer than the maximum width of the printed board Y to be used in this apparatus. Furthermore, as schematically shown in top and second rows of component feeding tables 12 in Fig. 2, the length between the centers of the left and right rotary tables 7 is set based on the width of the component feeding table 12. That is, this length is equal to or larger than the maximum array width of the plurality of the component feeding units 13 on the component feeding table 12, which is the length from the left end of the leftmost component feeding unit 13 to the right end of the rightmost component feeding unit 13 on the component feeding table 12. This is to avoid interference of the two component feeding tables 12 with each other when the two component feeding tables 12 are positioned between the left and right rotary tables 7, even if the two component feeding tables 12 move to closest positions to each other so that the suction nozzle 9 of the left rotary table 7 picks up the component from the leftmost component feeding unit 13 of the left component feeding table 12 and the suction nozzle 9 of the right rotary table 7 picks up the component from the rightmost component feeding unit 13 of the right component feeding table 12. Hereafter, description will be made on an operation with this structure in which the length between the centers of the left and right rotary tables 7 is twice as much as the maximum array length of the plurality of the component feeding units 13 on the component feeding table 12 or more.

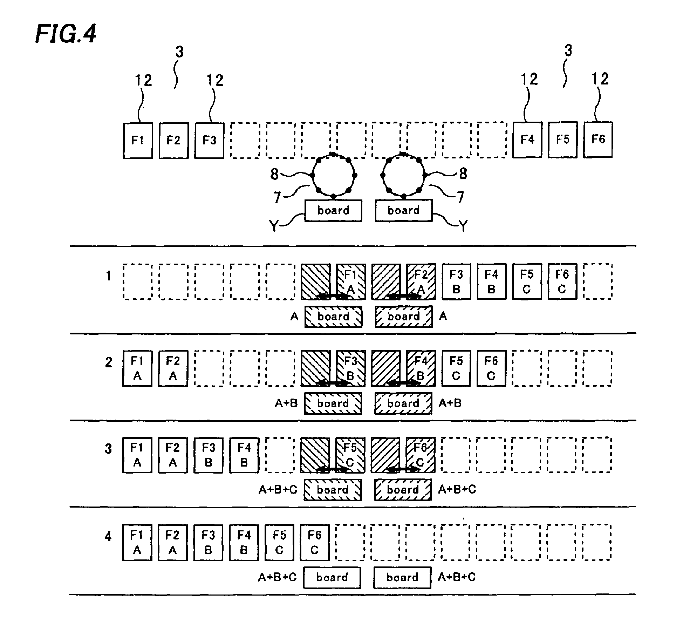

First, an electronic component mounting operation of a first embodiment of the invention will be descried with reference to Fig. 4. In this embodiment, twenty component feeding units 13 are arrayed on each of a leftmost table "F1" and a next table "F2" on the right among the six component feeding tables 12 so as to feed the same types of electronic components (shown as "A") therefrom, and twenty component feeding units 13 with same types of components are arrayed on each of third and fourth tables "F3" and "F4" and fifth and sixth tables "F5" and "F6" so as to feed the same types of electronic components from each two of the tables (shown as "B" and "C", respectively).

Then, as shown in a top row, the leftmost table "F1" among the component feeding tables 12 moves in a lateral direction as shown by an arrow in Fig. 4, the left rotary table 7 rotates, and the suction nozzle 9 of the mounting head 8 of the left rotary table 7 picks up the electronic component (component type "A") by suction from any one of the component feeding units 13 set on the leftmost table "F1" and mounts the component on the left printed board Y. That is, all the electronic components (component type "A") to be mounted from the plurality of the component feeding units 13 set on the leftmost table "F1" among the component feeding tables 12 are mounted on the left printed board Y. At the same time, the second table "F2" on the right among the component feeding tables 12 moves in the lateral direction as shown by an arrow, the right rotary table 7 rotates, and the suction nozzle 9 of the mounting head 8 of the right rotary table 7 picks up an electronic component (component type "A") by suction from any one of the component feeding units 13 set on the second table "F2" and mounts the component on the right printed board Y.

When the electronic components which the component feeding units 13 on the leftmost table "F1" and the second table "F2" can not feed are to be mounted, the leftmost table "F1" and the second table "F2" are moved to a wait position on a left end, as shown in a next row. Then, the suction nozzle 9 of the mounting head 8 of the left rotary table 7 picks up an electronic component (component type "B") by suction from any one of the component feeding units 13 set on the third table "F3" moved in the lateral direction and mounts the component on the left printed board Y. At the same time, the suction nozzle 9 of the mounting head 8 of the right rotary table 7 picks up an electronic component (component type "B") by suction from any one of the component feeding units 13 set on the fourth table "F4" moved in the lateral direction and mounts the component on the right printed board Y.

Furthermore, when the electronic components which the component feeding units 13 on the third and fourth tables "F3" and "F4" can not feed are to be mounted, the third and fourth tables "F3" and "F4" are moved to the wait position on the left end, as shown in a third row. Then, the suction nozzle 9 of the mounting head 8 of the left rotary table 7 picks up an electronic component (component type "C") by suction from any one of the component feeding units 13 set on the fifth table "F5" moved in the lateral direction and mounts the component on the left printed board Y. At the same time, the suction nozzle 9 of the mounting head 8 of the right rotary table 7 picks up an electronic component (component type "C") by suction from any one of the component feeding units 13 set on the sixth table "F6" moved in the lateral direction and mounts the component on the right printed board Y.

The component feeding units 13 on the component feeding table 12 moved to the wait position as described above, which are not used for the mounting operation, can undergo a replacement work of storage tapes storing electronic components, when having empty storage tapes. Furthermore, since twenty component feeding units 13 can be set on each of the component feeding tables 12, for example, sixty types of the electronic components at maximum can be mounted on each of the printed boards Y in this embodiment. Although each of the rotary tables 7 can perform intermittent rotation independently, the left and right printed boards Y can be of the same types and the same types of electronic components can be mounted in the same arrays on each of the left and right printed boards Y.

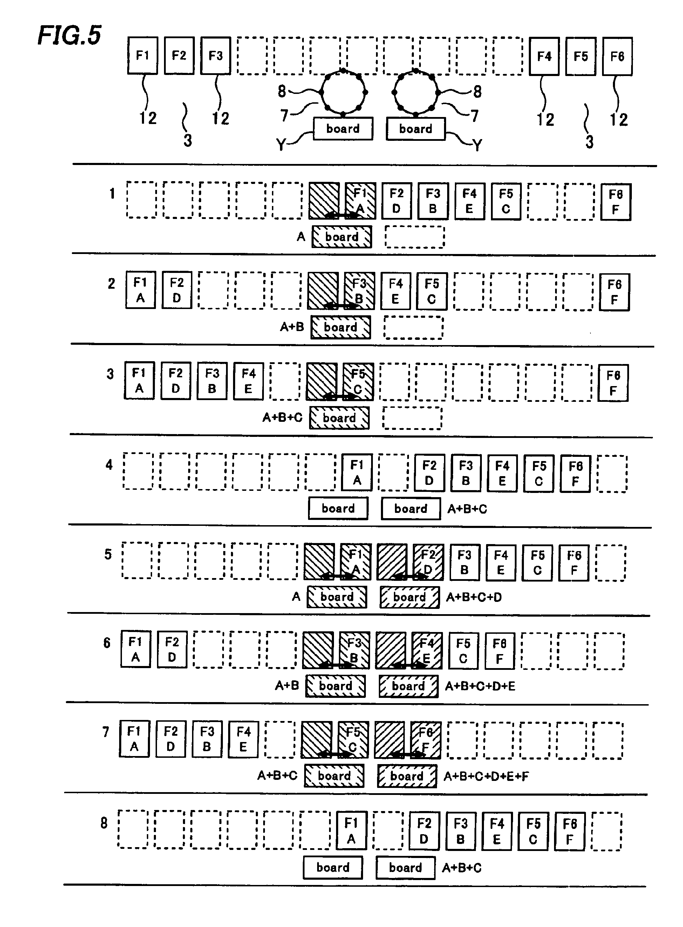

Next, an electronic component mounting operation of a second embodiment of the invention will be described with reference to Fig. 5. In this embodiment, the component types of the component feeding units 13 are different among the six component feeding tables 12, and the electronic components of a type "A" are set on the leftmost component feeding table 12 and the electronic components of types "D", "B", "E", "C", and "F" are respectively set on the following tables 12 in this order.

First, as shown in the top row, the leftmost table "F1" among the component feeding tables 12 moves in a lateral direction as shown by an arrow in Fig. 5, the left rotary table 7 rotates, and the suction nozzle 9 of the mounting head 8 of the left rotary table 7 picks up an electronic component (component type "A") by suction from any one of the component feeding units 13 set on the leftmost table "F1" and mounts the component on the left printed board Y.

Then, as shown in the next row, the leftmost table "F1" and a next table "F2" on the right among the component feeding tables 12 are moved to a wait position on a left end, and a third table "F3" moves in the lateral direction as shown by an arrow. Then, the left rotary table 7 rotates, and the suction nozzle 9 of the mounting head 8 of the left rotary table 7 picks up the electronic component (component type "B") by suction from any one of the component feeding units 13 set on the third table "F3" and mounts the component on the left printed board Y.

Then, as shown in the third row, the leftmost table "F1" to the fourth table "F4" among the component feeding tables 12 are moved to the wait position on the left end, and the fifth table "F5" moves in the lateral direction as shown by an arrow. Then, the left rotary table 7 rotates, and the suction nozzle 9 of the mounting head 8 of the left rotary table 7 picks up an electronic component (component type "C") by suction from any one of the component feeding units 13 set on the fifth table "F5" and mounts the component on the left printed board Y.

After the electronic components of types "A", "B", and "C" are mounted on the printed board Y on the left XY table 4A as described above, this printed board Y is moved onto the right XY table 4A as shown in the fourth row. Then, the leftmost table "F1" is moved so that the suction nozzle 9 of the mounting head 8 of the left rotary table 7 can pick up an electronic component (component type "A") from the leftmost table "F1" and mount the component on the printed board Y newly set on the left XY table 4A from upstream. At the same time, the second table "F2" is moved so that the suction nozzle 9 of the mounting head 8 of the right rotary table 7 can pick up an electronic component (component type "D") from the second table "F2" and mounts the component on the printed board Y (already mounted with the components of types "A", "B", and "C") moved from the left XY table 4A onto the right XY table 4A.

Then, as shown in the fifth row, the suction nozzle 9 of the mounting head 8 of the left rotary table 7 picks up an electronic component (component type "A") by suction from any one of the component feeding units 13 set on the leftmost table "F1" moved in the lateral direction and mounts the component on the left printed board Y. At the same time, the suction nozzle 9 of the mounting head 8 of the right rotary table 7 picks up an electronic component (component type "D") by suction from any one of the component feeding units 13 set on the second table "F2" moved in the lateral direction and mounts the component on the right printed board Y.

Then, as shown in the sixth row, the leftmost table "F1" and the next table "F2" on the right completing mounting operations of the electronic components of types "A" and "D respectively among the component feeding tables 12 are moved to the wait position on the left end. Then, the suction nozzle 9 of the mounting head 8 of the left rotary table 7 picks up an electronic component (component type "B") by suction from any one of the component feeding units 13 set on the third table "F3" moved in the lateral direction and mounts the component on the left printed board Y. At the same time, the suction nozzle 9 of the mounting head 8 of the right rotary table 7 picks up an electronic component (component type "E") by suction from any one of the component feeding units 13 set on the fourth table "F4" moved in the lateral direction and mounts the component on the right printed board Y.

Then, as shown in the seventh row, the leftmost table "F1" to the fourth table "F4" among the component feeding tables 12 are moved to the wait position on the left end. Then, the suction nozzle 9 of the mounting head 8 of the left rotary table 7 picks up an electronic component (component type "C") by suction from any one of the component feeding units 13 set on the fifth table "F5" moved in the lateral direction and mounts the component on the left printed board Y. At the same time, the suction nozzle 9 of the mounting head 8 of the right rotary table 7 picks up an electronic component (component type "F") by suction from any one of the component feeding units 13 set on the sixth table "F6" moved in the lateral direction and mounts the component on the right printed board Y.

Then, as shown in the eighth row, the printed board Y on the right XY table 4A mounted with the electronic components of types "D", "E", and "F" in addition to the components of types "A", "B", and "C" is conveyed to downstream, and the printed board Y on the left XY table 4A mounted with the electronic components of types "A", "B", and "C" is moved onto the right XY table 4A. Then, a new printed board Y is conveyed from upstream onto the left XY table 4A. Then, in the same manner as the operation shown in the fifth row, the suction nozzle 9 of the mounting head 8 of the left rotary table 7 picks up an electronic component (component type "A") by suction from any one of the component feeding units 13 set on the leftmost table "F1" moved in the lateral direction and mounts the component on the left printed board Y. At the same time, the suction nozzle 9 of the mounting head 8 of the right rotary table 7 picks up an electronic component (component type "D") by suction from any one of the component feeding units 13 set on the second table "F2" moved in the lateral direction and mounts the component on the right printed board Y.

The component mounting operation is then repeated in the same manner as above. On the printed board Y on the left XY table 4A, the electronic component of types "A", "B", and "C" are mounted by using the left rotary table 7. On the printed board Y on the right XY table 4A, the electronic components of types "D", "E", and "F" are mounted by using the right rotary table 7, in addition to the components of types "A", "B", and "C" which are already mounted thereon. That is, the operation of mounting all the electronic components on the printed board is completed by using both the XY tables 4A and both the rotary tables 7.

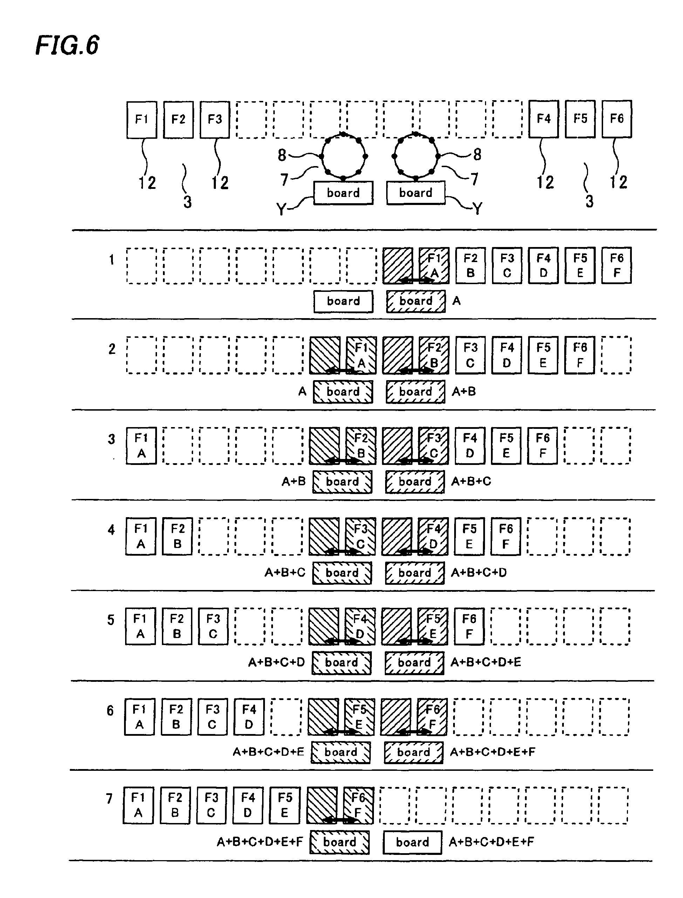

Next, an electronic component mounting operation of a third embodiment of the invention will be described with reference to Fig. 6. In this embodiment, the component feeding units 13 are arrayed on each of the six component feeding tables 12 so that the electronic components of types "A", "B", "C", "D", "E", and "F" can be fed respectively from a leftmost table "F1" to a sixth table "F6" in this order.

Then, as shown in the top row, the leftmost table "F1" among the component feeding tables 12 moves in a lateral direction as shown by an arrow, the right rotary table 7 rotates, and the suction nozzle 9 of the mounting head 8 of the right rotary table 7 picks up an electronic component (component type "A") by suction from any one of the component feeding units 13 mounted on the leftmost table "F1" and mounts the component on the right printed board Y.

Then, as shown in the second row, the leftmost table "F1" is moved to a position corresponding to the left rotary table 7, and the second table "F2" on the right is moved to a position corresponding to the right rotary table 7. Then, the leftmost table "F1" moves in a lateral direction as shown by an arrow, the left rotary table 7 rotates, and the suction nozzle 9 of the mounting head 8 of the left rotary table 7 picks up an electronic component (component type "A") by suction from any one of the component feeding units 13 set on the leftmost table "F1" and mounts the component on the left printed board Y. At the same time, the second table "F2" moves in the lateral direction as shown by an arrow, the right rotary table 7 rotates, and the suction nozzle 9 of the mounting head 8 of the right rotary table 7 picks up an electronic component (component type "B") by suction from any one of the component feeding units 13 set on the second table "F2" and mounts the component on the right printed board Y in addition to the component of a type "A".

Then, as shown in the third row, the leftmost table "F1" is moved to a wait position on a left end, the second table "F2" is moved to the position corresponding to the left rotary table 7, and the third table "F3" is moved to the position corresponding to the right rotary table 7. Then, the left rotary table 7 rotates, and the suction nozzle 9 of the mounting head 8 of the left rotary table 7 picks up an electronic component (component type "B") by suction from any one of the component feeding units 13 set on the second table "F2" and mounts the component on the left printed board Y in addition to the component of a type "A". At the same time, the right rotary table 7 rotates, and the suction nozzle 9 of the mounting head 8 of the right rotary table 7 picks up an electronic component (component type "C") by suction from any one of the component feeding units 13 set on the third table "F3" and mounts the component on the right printed board Y in addition to the components of types "A" and "B".

Then, as shown in the fourth row, the leftmost table "F1" and the next table "F2" on the right among the component feeding tables 12 are moved to the wait position on the left end, the third table "F3" is moved to the position corresponding to the left rotary table 7, and the fourth table "F4" is moved to the position corresponding to the right rotary table 7. Then, the left rotary table 7 rotates, and the suction nozzle 9 of the mounting head 8 of the left rotary table 7 picks up an electronic component (component type "C") by suction from any one of the component feeding units 13 set on the third table "F3" and mounts the component on the left printed board Y in addition to the components of types "A" and "B". At the same time, the right rotary table 7 rotates, and the suction nozzle 9 of the mounting head 8 of the right rotary table 7 picks up an electronic component (component type "D") by suction from any one of the component feeding units 13 on the fourth table "F4" and mounts the component on the right printed board Y in addition to the components of types "A", "B" and "C".

Then, as shown in the fifth row, the leftmost table "F1" to the third table "F3" among the component feeding tables 12 are moved to the wait position on the left end, the fourth table "F4" is moved to the position corresponding to the left rotary table 7, and the fifth table "F5" is moved to the position corresponding to the right rotary table 7. Then, the left rotary table 7 rotates, and the suction nozzle 9 of the mounting head 8 of the left rotary table 7 picks up an electronic component (component type "D") by suction from any one of the component feeding units 13 set on the fourth table "F4" and mounts the component on the left printed board Y in addition to the components of types "A", "B", and "C". At the same time, the right rotary table 7 rotates, and the suction nozzle 9 of the mounting head 8 of the right rotary table 7 picks up an electronic component (component type "E") by suction from any one of the component feeding units 13 set on the fifth table "F5" and mounts the component on the right printed board Y in addition to the components of types "A", "B", "C", and "D".

Then, as shown in the sixth row, the leftmost table "F1" to the fourth table "F4" among the component feeding tables 12 are moved to the wait position on the left end, the fifth table "F5" is moved to the position corresponding to the left rotary table 7, and the sixth table "F6" is moved to the position corresponding to the right rotary table 7. Then, the left rotary table 7 rotates, and the suction nozzle 9 of the mounting head 8 of the left rotary table 7 picks up an electronic component (component type "E") by suction from any one of the component feeding units 13 set on the fifth table "F5" and mounts the component on the left printed board Y in addition to the components of types "A", "B", "C", and "D". At the same time, the right rotary table 7 rotates, and the suction nozzle 9 of the mounting head 8 of the right rotary table 7 picks up an electronic component (component type "F") by suction from any one of the component feeding units 13 set on the sixth table "F6" and mounts the component on the right printed board Y in addition to the components of types "A", "B", "C", "D", and "E".

Then, as shown in the seventh row, the leftmost table "F1" to the fifth table "F5" among the component feeding tables 12 are moved to the wait position on the left end, the sixth table "F6" is moved to the position corresponding to the left rotary table 7, and the printed board Y on the right XY table 4A mounted with the electronic components of types "A", "B", "C", "D", "E", and "F" is conveyed to downstream. Then, the left rotary table 7 rotates, and the suction nozzle 9 of the mounting head 8 of the left rotary table 7 picks up an electronic component (component type "F") by suction from any one of the component feeding units 13 set on the sixth table "F6" and mounts the component on the left printed board Y in addition to the components of types "A", "B", "C", "D" and "E".

Accordingly, the printed board Y on the left XY table 4A can be also mounted with the electronic components of types "A", "B", "C", "D", "E", and "F", and conveyed to downstream. Then, the mounting operation returns to the operation shown in the top row, and the electronic components of types "A", "B", "C", "D", "E", and "F" are to be mounted on the printed boards Y on the right and left XY tables 4A in the same manner.

As described above, in the described embodiments of the invention, the suction nozzles 9 of the mounting heads 8 provided on each of the plurality of the rotary tables 7 can perform the mounting operation of the electronic components, respectively and independently. Furthermore, the XY tables 4A for moving the printed boards Y in a horizontal direction and positioning the board Y on the component mounting positions can be moved respectively and independently, and the structure is simplified, so that the operations of mounting the electronic components on the plurality of the printed boards Y can be performed independently.

In any of the embodiments, when the component feeding table 12 completing the operation of picking up electronic components from its component feeding units 13 is moved and the operation is shifted to the operation of picking up electronic components from the component feeding units 13 set on the other component feeding table 12, the component feeding table 12 completing the pickup operation is not allowed to return to an operating position during the shifted operation, in principle. Furthermore, the plurality of the component feeding tables 12 is configured to move in the arraying direction of the tables 12 so that the productivity of the printed boards becomes significantly high.

Furthermore, the plurality of the component feeding tables 12 is respectively and independently moved in the arraying direction of the tables 12, so that the component feeding units 13 of any one of the component feeding tables 12 can be positioned in the component feeding positions and the operations of mounting electronic components can be performed by the plurality of the rotary tables 7. Therefore, it is not necessary to array the plurality of the component feeding tables 12 in plural rows corresponding to the plurality of the rotary tables 7, so that a drive source and a space for the tables are needed for only one row.

Furthermore, since the operations of mounting electronic components on the plurality of the printed boards Y can be performed by the suction nozzles 9 of the mounting heads 8 in each of the plurality of the rotary tables independently, the operations can be applied to various printed boards such as a plurality of printed boards having no relation with each other or printed boards which is to complete the mounting operation of all the components by both the rotary tables 7 in such a manner that a printed board having electronic components mounted by one rotary table 7 is then mounted with electronic components by the other rotary table 7.

As schematically shown in the second and third rows of the XY tables 4A from the top in Fig. 2, the length between the centers of the left and right rotary tables 7 is a little longer than the maximum width of the printed board Y to be used in the embodiments, in the described embodiments. However, as shown in the fourth row, the printed boards Y are positioned and set on inner sides of the arrayed XY tables 4A by the positioning device, and the printed boards Y each having about half a maximum width of the printed board Y used in the embodiments are set on the XY tables 4A respectively. This can prevent both the XY tables 4A from interfering with each other when the electronic components are mounted on the printed boards Y. Furthermore, if it matters little if the electronic component mounting apparatus becomes larger, the length between the centers of the left and right rotary tables 7 is made twice as much as the maximum width of the printed board Y to be used in the apparatus or more, so that the XY tables 4A do not interfere with each other when the mounting operation of the electronic components is performed.

It has been described that the length between the centers of the left and right rotary tables 7 is made twice as much as the maximum array width of the plurality of the component feeding units 13 on the component feeding table 12 or more so as to avoid the interference of both the component feeding tables 12 with each other if it matters little if the electronic component mounting apparatus becomes larger. However, if the larger apparatus is not required, that is, if the electronic component mounting apparatus is required to be miniaturized, the length between the centers of the rotary tables 7 is made more than the maximum array length of the plurality of the component feeding units 13 on the component feeding table 12, for example 1.5 times as much as that. This makes it possible that an electronic component is picked up from the leftmost component feeding unit 13 on one component feeding table 12 and simultaneously an electronic component is picked up from a left-side component feeding unit 13 on the adjacent component feeding table 12 without the interference of both the component feeding tables 12 with each other. Alternatively, this makes it possible that an electronic component is picked up from the rightmost component feeding unit 13 on one component feeding table 12 and simultaneously an electronic component is picked up from a right-side component feeding unit 13 on the adjacent component feeding table 12 without the interference of both the component feeding tables 12 with each other.

Although particular embodiments of the invention have been disclosed in detail, it will be recognized that variations or modifications of the invention are possible based on the disclosure and lie within the scope as defined by the accompanying claims.

## Claims

1. An electronic component mounting apparatus comprising:
- two or more of component feeding units (13) that are aligned in an alignment direction and movable along the alignment direction;
- two or more of rotary tables (7) that are aligned in the alignment direction, each of the rotary tables (7) comprising a plurality of mounting heads (8) disposed at peripheral portions of the rotary table (7) for picking up electric components (A-F) from the component feeding units (13); and
- two or more of positioning tables (4A) that are aligned in the alignment direction, each of the positioning tables (4A) positioning a printed board (Y) so that the electric components (A-F) picked up by the mounting heads (8) are mounted on the printed board (Y).

2. The apparatus of claim 1, wherein the component feeding units (13) are configured to run on a single track so that the component feeding units (13) take turns to be positioned for the picking up by the mounting heads (8).

3. The apparatus of claim 1 or 2, further comprising a component recognition camera for taking images of the electronic components (A-F) picked up by the mounting heads (8) and motors for moving corresponding positioning tables (4A) for positional correction based on the images taken by the recognition camera.

4. The apparatus according to any of claims 1 to 3, wherein each of the positioning tables comprises a positioning device for positioning the printed board (Y).

5. An electronic component mounting apparatus comprising:
- two or more of component feeding tables (12) that are aligned in an alignment direction and movable along the alignment direction, each of the component feeding tables (12) comprising more than one component feeding unit (13);
- two or more of rotary tables (7) that are aligned in the alignment direction, each of the rotary tables (7) comprising a plurality of mounting heads (8) disposed at peripheral portions of the rotary table (7) for picking up electric components (A-F) from the component feeding units (13); and
- two or more of positioning tables that are aligned in the alignment direction, each of the positioning tables positioning a printed board so that the electric components (A-F) picked up by the mounting heads (8) are mounted on the printed board (Y).

6. The apparatus of claim 5, wherein the component feeding tables (12) are configured to run on a single track so that the component feeding tables (12) take turns to be positioned for the picking up by the mounting heads (8).

7. The apparatus of claim 5 or 6, further comprising a component recognition camera for taking images of the electronic components (A-F) picked up by the mounting heads and motors for moving corresponding positioning tables for positional correction based on the images taken by the recognition camera.

8. The apparatus according to any of claims 5 to 7, wherein each of the positioning tables comprises a positioning device for positioning the printed board.

9. The apparatus according to any of claims 5 to 8, wherein a length between centers of the plurality of the rotary tables (7) is twice as much as a maximum array width of the plurality of the component feeding units (13) or more.

10. The apparatus according to any of claims 5 to 8, wherein a length between centers of the plurality of the rotary tables (7) is more than a maximum array width of the plurality of the component feeding units (13).

11. The apparatus according to any of claims 5 to 10, wherein each of the mounting heads (8) comprises a suction nozzle (9) which is configured to pick up the electronic component (A-F) from any of the component feeding tables (12).
